# EUROPEAN PATENT APPLICATION

(11) **EP 4 607 808 A1**
(43) Date of publication of application: **27.08.2025**
(21) Application number: 24159620.4
(22) Date of filing: 26.02.2024
(51) Int. Cl.: H04B 3/46, H04J 3/06, G01R 31/08

(54) **SYSTEM AND METHOD OF CALIBRATING A CLOCK DEVICE**

(71) Applicant: Adtran Networks SE, 98617 Meiningen (DE)
(72) Inventor: Hayun, Avi, 4451914 Kfar-Saba (IL)
(74) Representative: Grünecker Patent- und Rechtsanwälte PartG mbB

(57) **Abstract**

There is provided a technique for calibrating a clock device operatively connected to an antenna and receiving precision time therefrom via a cable. The technique enables increasing the accuracy of the clock device by in-band time calibration thereof with the help of continuously sampling antenna cable delays and enabling respective time corrections. The method of calibrating comprises: a) upon disabling antenna's powering, generating by a measurement tool implemented within the clock device a pulse toward the unpowered antenna; b) measuring, by the measurement tool, the roundtrip delay between the generated pulse and a measured signal reflected by the antenna, thereby obtaining a cable delay; and c) providing time correction in the clock device in accordance with the cable delay. Continuously repeating operations a) - c) can enable in-band compensation for varying cable delay.

## Description

### TECHNICAL FIELD

The presently disclosed subject matter relates to the field of data communication, and, more particularly, to time calibration of clock devices in data networks.

### BACKGROUND

Proper operation of a data network (e.g. a telecommunication network, a distributed computer system, etc.) requires phase and/or frequency synchronization between various entities therein. Synchronization can be achieved, for example, by exchanging timing information (time-transfer) across the network in accordance with time-transfer (TT) protocols (e.g. IEEE 1588 Precision Time Protocol (PTP), Network Time Protocol (NTP), etc.

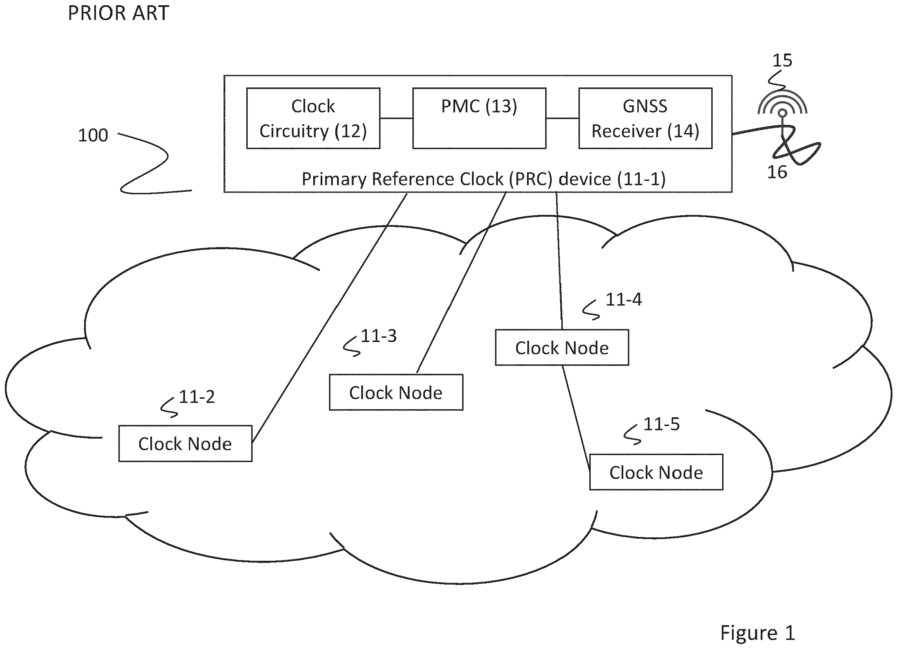

**Fig. 1** schematically illustrates a non-limiting example of time distribution network **100**, including a plurality of clock nodes (referred to hereinafter also as clock devices) denoted as **11-1** - **11-5** and implementing a time-transfer protocol as known in prior art. The exemplary time distribution network **100** can operate on top of a packet-compatible communication network (not shown) which comprises a plurality of network nodes organized in ring, bus, tree, star, or mesh topologies, or a combination of different topologies. Clock nodes correspond to hosting network nodes of the underlying data network and can constitute parts of the respective network nodes.

Each clock node comprises a processing and memory circuitry (PMC) and a clock circuitry.

Clock nodes **11-2** - **11-4** are operatively connected to the clock node **11-1** via respective clock ports (not shown). Clock node **11-1** is configured to be the source of synchronization data in the network, i.e. to serve as a primary reference clock (PRC) node providing the timing reference to the clock nodes **11-2** - **11-4.**

Clock node 11-1 (referred to hereinafter as PRC device) receives Coordinated Universal Time (UTC)-based time information from an external time reference, most commonly a GNSS (Global Navigation Satellite System) source. Clock node **11-4** is configured as a boundary clock node and is configured to provide reference time information to node **11-5.**

For the purpose of illustration only, the following description is provided for a GNSS source of the external time reference and GNSS receiver, accordingly. Those skilled in the art will readily appreciate that the teachings of the presently disclosed subject matter are, likewise, applicable to any other suitable satellite constellation including STL (Satellite Time and Location).

Further to clock circuitry **12** and PMC **13**, PRC device **11-1** comprises GNSS receiver **14** connected to an antenna device **15** with the help of cable **16** (referred to hereinafter also as "antenna cable"). It is noted that antenna cable **16** can be any cable suitable for connection between antenna **15** and GNSS receiver **14** (e.g. coaxial cable, fiber, etc.). It is further noted that antenna device **15** (referred to hereinafter as "antenna") comprises one or more electronic components (e.g. an amplifier and/or other signal processing elements) and need to be powered for its operation. In certain embodiments, PRC device **11-1** can operate as a power source for antenna **15.**

By way of non-limiting example, GNSS receiver **14** can be a GNSS disciplined oscillator that constantly receives signals from satellites via antenna **15** and adjusts its clock to maintain precise time synchronization.

Clock circuitry **12** takes the precise time information received from the GNSS receiver **14** and generates highly accurate time signals. These signals are then distributed across the time distribution network **100** to synchronize various devices and systems to the same precise time.

GNSS UTC time is determined when a signal is received at antenna **15.** Accordingly, cable **16** between antenna **15** and GNSS receiver **14** causes signal propagation delays (referred to hereinafter also as "cable delays"), thus reducing accuracy of time calculation at GNSS receiver **14.**

The contemporary art assumes that the expected delays in antenna cable (referred to hereinafter also as "cable delays") can be calculated in accordance with the cable length and specification or can be measured by an external test device and, accordingly, PRC devices can be calibrated prior to operation.

### GENERAL DESCRIPTION

For the purpose of illustration only, the following description is provided for a PRC device. Those skilled in the art will readily appreciate that the teachings of the presently disclosed subject matter are, likewise, applicable to any other clock device receiving precise time via cable.

The inventor has recognized that obtaining cable length/specification data before or during installation can present a formidable task. Furthermore, antenna cable length and characteristics may vary during the operation of PRC device, for example due to temperature variations and/or aging of the cable. Therefore, the respective cable delays are not constant, and the preliminary calibration is not stable and not always available.

Accordingly, the inventor has appreciated that there is a need to provide in-band continuous calibration of a PRC device to compensate for the varying antenna cable delays with minimized disruption to the normal operation of the device. Further, there is a need to eliminate the necessity of knowing cable length and specifications during the device installation.

In accordance with the presently disclosed subject matter, there is provided a technique of increasing the accuracy of a clock device by in-band calibrating thereof with the help of continuously sampling antenna cable delays and enabling respective time corrections.

In accordance with certain aspects of the presently disclosed subject matter, there is provided a method of time calibration of a clock device operatively connected to antenna and receiving precision time information therefrom via a cable. The method comprises: a) generating by a measurement tool implemented within the clock device a pulse toward the antenna; b) measuring, by the measurement tool, the roundtrip delay between the generated pulse and a measured signal reflected by antenna, thereby obtaining a cable delay; and c) providing time correction in the clock device in accordance with the measured cable delay.

The method can further comprise continuously repeating operations a) - c), thereby enabling in-band compensation for varying cable delay.

The method can further comprise switching to a measurement mode prior to generating the pulse towards the antenna, wherein the switching is provided within the clock device and comprises enabling reflected signals incoming from antenna to be routed to the measurement tool.

In accordance with further aspects of the presently disclosed subject matter, measuring the roundtrip delay between the generated pulse and the signal reflected by antenna can comprise setting a threshold value defining when a reflected signal is recognized as the measured signal reflected by antenna. Thus, a reflected signal is recognized as the measured signal when the absolute value of an amplitude thereof exceeds the threshold value.

The measurement tool can change the threshold value and sample reflected signals at the respective sampling points. The method can further comprise providing multiple sampling at each of several sampling points and determining the optimal sampling point enabling the minimal deviation of sampling results repeated at a specific point, wherein the measured signal reflected by antenna is sampled at the optimal sampling point.

In accordance with further aspects of the presently di sclosed subject matter, the method can further comprise: prior to connecting the cable to antenna, generating by the measurement tool a pulse toward the cable; measuring, by the measurement tool, the roundtrip delay between the generated pulse and an open-end reflected signal, thereby obtaining an open-end cable delay; and using the open-end cable delay as a baseline when obtaining the cable delay or to calculate a length of the cable.

In accordance with other aspects of the presently disclosed subject matter, there is provided a clock device operatively connected to antenna and receiving precision time therefrom via a cable, the clock device comprising a measurement tool and configured to perform the method of calibration as disclosed above.

The clock device can be configured to operate as primary reference clock device. The clock device can comprise GNSS (Global Navigation Satellite System) receiver operatively connected to a grandmaster clock device.

In accordance with other aspects of the presently disclosed subject matter, there is provided a GNSS receiver operatively connected to antenna and receiving precision time therefrom via a cable, the GNSS receiver comprising a measurement tool and configured to perform the method of time calibration as disclosed above.

In accordance with other aspects of the presently disclosed subject matter, there is provided a grandmaster clock operatively connected to antenna and receiving precision time therefrom via a cable, the grandmaster clock comprising a measurement tool and configured to perform the method of time calibration as disclosed above.

Among advantages of certain embodiments of the presently disclosed subject matter are eliminating necessity in knowing cable specifications and length; in-band capability to compensate temperature and aging effects during PRC device operation; capability to detects damages on the cable, etc.

### BRIEF DESCRIPTION OF THE DRAWINGS

To understand the invention and to see how it can be carried out in practice, embodiments will be described, by way of non-limiting examples, with reference to the accompanying drawings, in which:
**Fig. 1** illustrates a generalized schematic architecture of an exemplary time distribution network as known in prior art;
**Fig. 2a** illustrates a generalized flow chart of time calibrating a PRC device in accordance with certain embodiments of the presently disclosed subject matter;
**Fig. 2b** illustrates reflection signal in open cable and in connected non-powered antenna;
**Fig. 3a** illustrates a generalized block diagram of a PRC device in accordance with certain embodiments of the presently disclosed subject matter;
**Fig. 3b** illustrates a schematic diagram of operating the PRC device in accordance with certain embodiments of the presently disclosed subject matter; and
**Fig. 4** illustrates a generalized flow chart of operating a measurement unit in PRC device in accordance with certain embodiments of the presently disclosed subject matter.

### DETAILED DESCRIPTION

In the following detailed description, numerous specific details are set forth to provide a thorough understanding of the invention. However, it will be understood by those skilled in the art that the presently disclosed subject matter may be practiced without these specific details. In other instances, well-known methods, procedures, components and circuits have not been described in detail so as not to obscure the presently disclosed subject matter.

It is to be understood that the term "signal" used herein excludes transitory propagating signals but includes any other signal suitable to the presently disclosed subject matter.

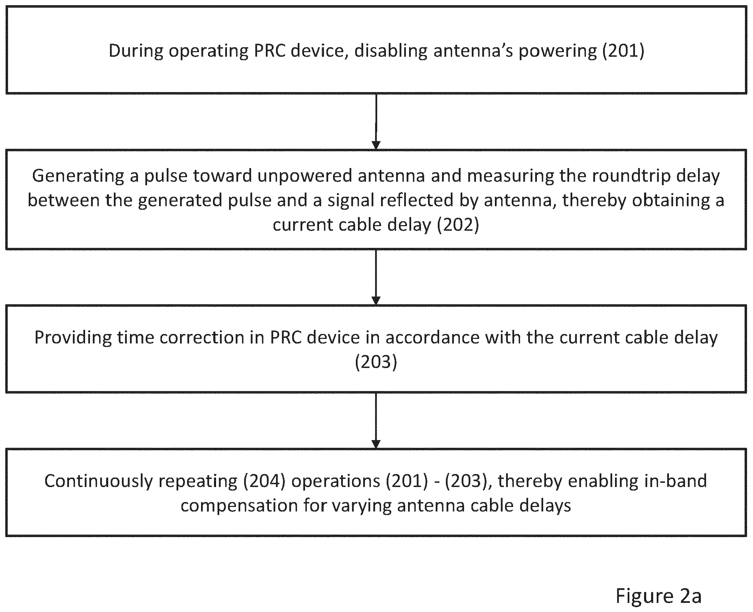

Bearing this in mind, attention is drawn to Fig. 2a illustrating a generalized flow chart of in-band calibrating a PRC device.

In accordance with certain embodiments of the presently disclosed subject matter, in-band time calibrating the PRC device is provided with the help of continuously sampling antenna cable delays and enabling the respective time corrections.

Unless specifically stated otherwise, throughout the specification the term "in-band time calibration", "in-band compensation", "in-band measuring" and alike refer to the respective processes provided with the help of the measurement tools implemented within a device and during the normal operation of the device.

Unless specifically stated otherwise, throughout the specification the terms "continuously sampling", "continuously correcting" or alike refer to actions provided periodically and/or responsive to scheduled events and/or responsive to predefined events (e.g. predefined thresholds of changes of an external temperature, detected cable damages, etc.).

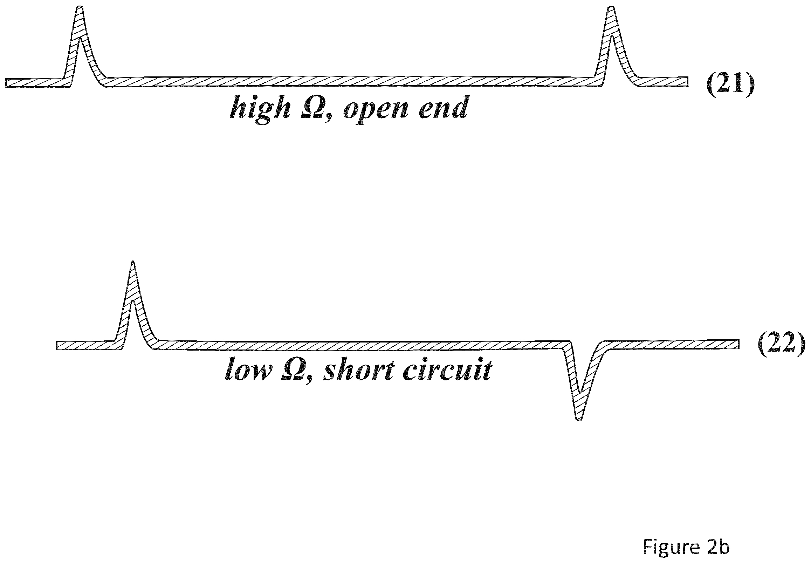

As known, the reflection coefficient is the ratio of reflected wave to incident wave at point of reflection. This value varies from -1 (for short load) to +1 (for open load). Accordingly, as illustrated in **Fig. 2b**, the reflected signal is positive in the case (**21**) of open cable and negative in the case (**22**) for unpowered antenna which can be considered as a near "short load" case.

For the purpose of illustration only, the following description is provided for embodiments, sampling the antenna cable delays with unpowered antenna (reflection coefficient value about -1), i.e. antenna disconnected from an external power source (e.g. PRC device) or with disconnected antenna (reflection coefficient value about +1). Those skilled in the art will readily appreciate that the teachings of the presently disclosed subject matter are, likewise, applicable to sampling antenna cable delays also with the reflection sign and magnitude in the range between -1 and +1 depending on the impedance level.

In accordance with certain embodiments, the PRC device generates (**201**) a pulse toward antenna and measures the roundtrip delay between the generated pulse and a signal reflected by antenna, thereby obtaining (**202**) a current cable delay. As the roundtrip delay includes both the forward and backward propagation, the current cable delay (i.e. one-way propagation delay between the PRC device and antenna) can be calculated as the total roundtrip delay divided by two.

Further, the PRC device corrects (**203**) its clock information in accordance with the measured current cable delay.

PRC device continuously repeats (**204**) operations (**201**) - (**203**), thereby enabling in-band compensation for varying antenna cable delays.

In certain embodiments, the above measurements can be provided upon disabling antenna's powering. Optionally, PRC device can, in a similar manner, can measure the roundtrip delay prior to operation, when the cable is not yet connected to the antenna (open-end reflection). The resulting cable delay can be used to calculate the cable length and/or used as an accurate baseline for further in-band delay measurements.

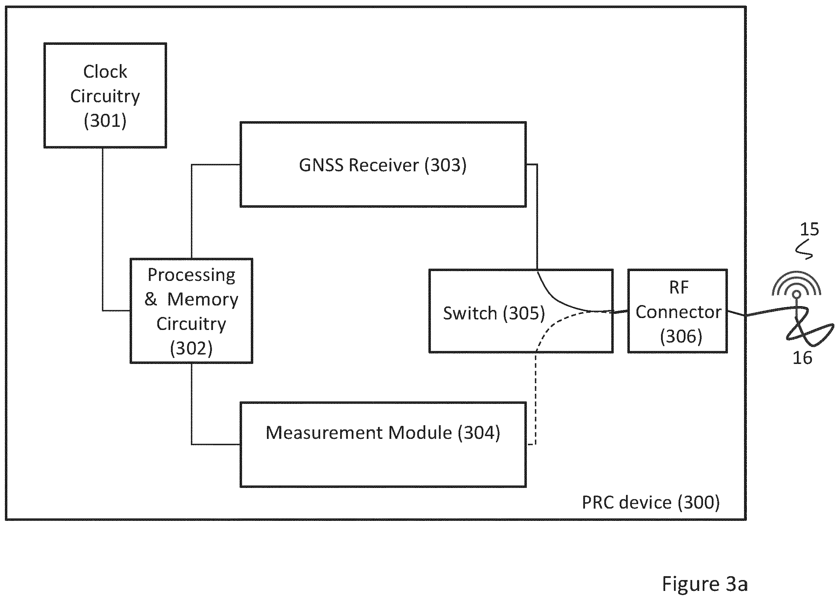

Referring to **Fig. 3a**, there is illustrated a generalized block diagram of a PRC device in accordance with certain embodiments of the presently disclosed subject matter.

PRC device **300** comprises a clock circuitry **301** operatively connected to a processing and memory circuitry (PMC) **302.** PMC **302** is operatively connected to a GNSS receiver **303** and a measurement module **304.** RF connector **306** is configured to enable connection of PRC device **300** to antenna cable **16.** GNSS receiver **303** and measurement module **304** are operatively connected to switch **305** configured to provide them with switchable operative connection to RF connector **306.**

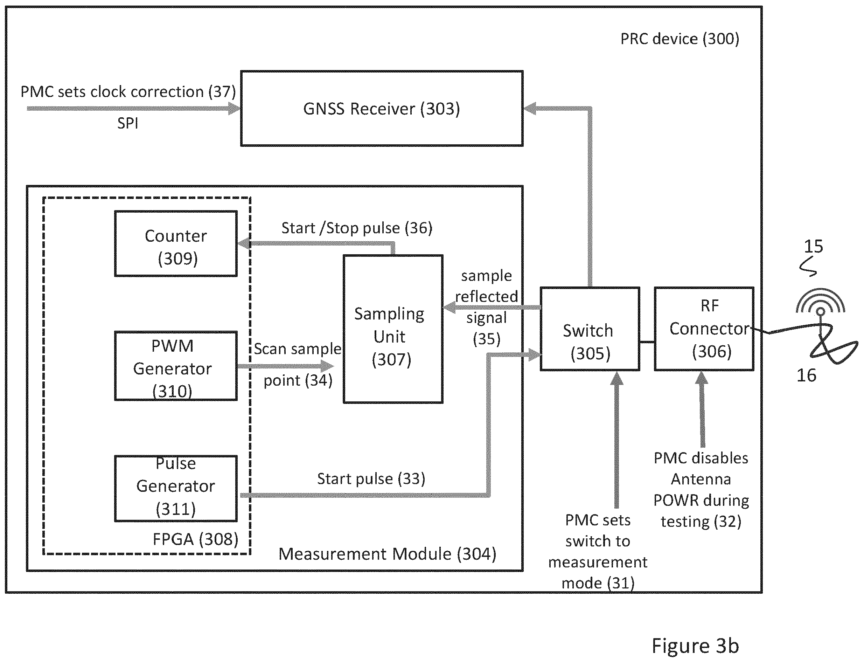

**Fig. 3b** illustrates a schematic diagram that details the PRC device and operation thereof in accordance with certain embodiments of the presently disclosed subject matter.

Measurement module **304** comprises a sampling unit **307** operatively connected to switch **305**, a counter **309** and a PWM (Pulse Width Modulation) generator **310.** Measurement module **304** further comprises a pulse generator **311** operatively connected to counter **309** and to switch **305.** PMC **302** (not shown in **Fig. 3b** for simplicity of illustration) is operatively connected to GNSS receiver **303**, switch **305** and RF connector **306.** Optionally, counter **309**, PWM generator **310** and pulse generator **311** can be integrated into a Field Programmable Gate Array (FPGA) **308** operatively connected to PMC **302.**

Switch **305** (e.g. an RF switch) is configured to switch between operation mode when signals incoming from antenna **15** are routed to GNSS receiver **303** and measurement mode enabling measuring the cable delays. PMC **302** continuously (i.e. periodically and/or responsive to scheduled events and/or responsive to predefined events) sets (**31**) switch **305** to the measurement mode. Concurrently, PMC **302** disables (**32**), at the beginning of measurement mode, antenna powering via RF connector **306** and enables antenna powering back when sampling is finished.

Responsive to a command received from PMC **302** upon disabling antenna powering, pulse generator **311** generates (**33**) a start pulse and sends it to switch **305.** Switch **305** enables transferring the start pulse to counter **309.**

Sampling unit **307** can be configured as a high-speed comparator capable of providing indication (stop pulse) when an absolute value of an amplitude of a reflected signal is higher than the threshold value of comparator's negative input point. Setting the threshold (and a respective sampling point) can be controlled by PWM generator **310.** PWM generator **310** changes the threshold and enables scanning (**34**) of sampling points.

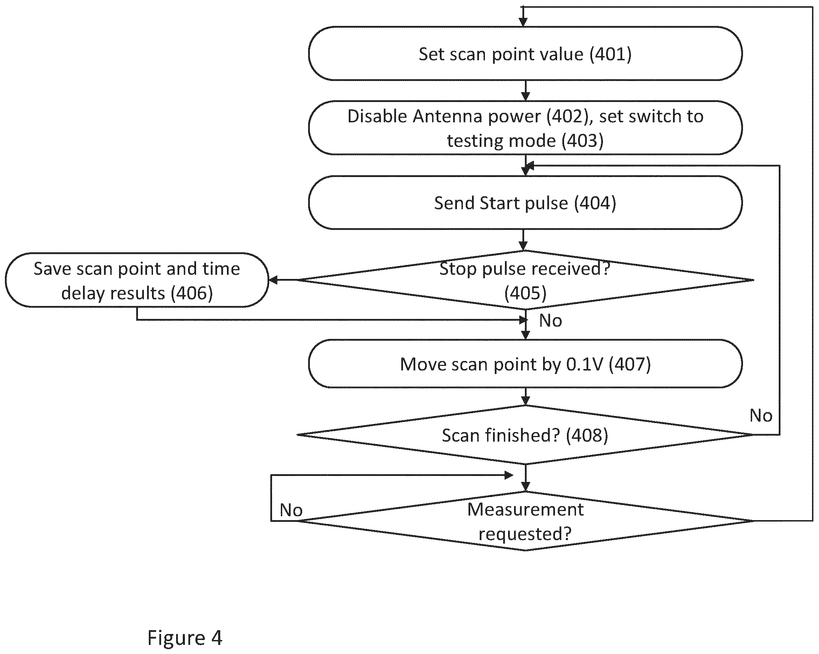

Sampling unit samples (**35**) reflected signal as further detailed with reference to **Fig. 4** and provides (**36**) stop pulse to counter (**309**).

In certain embodiments, sampling is provided at the optimal sampling point enabling minimized threshold whilst the minimized deviation of sampling results repeated at the point. The optimal point can be determined by obtaining multiple samples at each of several sampling points and selecting the sampling point optimized by minimized deviations of sampling results and the threshold.

Counter (**309**) measures the roundtrip time between the start pulse and the stop pulse. Upon time-to-digital conversion, counter (**309**) sends the respective data to PMC **302** which calculates and sets (**37**) time corrections accordingly.

In certain embodiments PMC **302** can set the respective time corrections in GNSS receiver **303**, while in other embodiments the time corrections can be provided directly in clock circuitry **301.**

It is noted that the teachings of the presently disclosed subject matter are not bound by embodiments described with reference to **Fig. 1**, **Fig. 3a** and **Fig. 3b****.** Equivalent and/or modified functionality can be consolidated or divided in another manner and can be implemented in any appropriate combination of software with firmware and/or hardware. Grandmaster/Boundary clock, GNSS receiver and measurement module can be integrated in a single enclosure or, alternatively, at least one of them can be implemented in a separate enclosure constituting a part of PRC device.

Likewise, a measurement module configured in accordance with the teachings of the presently disclosed subject matter can be integrated with clock circuitry of non-PRC device receiving precise time via cable.

Referring to **Fig. 4**, a generalized flow chart of operating a measurement unit in PRC device in accordance with certain embodiments of the presently disclosed subject matter.

After PRC device **300** is installed, measurement module sets (**401**) scan point value (i.e. threshold), disables (**402**) antenna powering and sets (**403**) switch to testing mode. It is noted that operations (**401**) - (**403**) can be provided simultaneously or in any order.

When operations (**401**) - (**403**) are completed, measurement module **304** sends (**404**) start pulse towards cable **16** and checks (**405**) if stop pulse is received.

When the stop pulse is received, measurement module **304** saves (**406**) scan point value and time delay results. As detailed above with reference to **Figs. 2 - 3**, the time delay results are further usable for time correction. Changes in scan point value can be indicative of antenna/cable state.

If the absolute value of amplitude of the reflected signal is less than the threshold corresponding to scan point and no stop pulse is received, measurement module **304** incrementally (e.g. with 0.1V interval) changes threshold value and moves (**407**) scan point accordingly. Measurement module **304** repeats operations **404 - 407** until receiving stop pulse or otherwise finishing (**408**) the scan (e.g. due to timeout).

It is noted that applying the threshold scanning as detailed above enables sampling roundtrip cable delays also under conditions of connected and powered antenna.

It is to be understood that the invention is not limited in its application to the details set forth in the description contained herein or illustrated in the drawings. The invention is capable of other embodiments and of being practiced and carried out in various ways. Hence, it is to be understood that the phraseology and terminology employed herein are for the purpose of description and should not be regarded as limiting. As such, those skilled in the art will appreciate that the conception upon which this disclosure is based may readily be utilized as a basis for designing other structures, methods, and systems for carrying out the several purposes of the presently disclosed subject matter.

It will also be understood that the system according to the invention may be, at least partly, implemented on a suitably programmed computer. Likewise, the invention contemplates a computer program being readable by a computer for executing the method of the invention. The invention further contemplates a non-transitory computer-readable memory tangibly embodying a program of instructions executable by the computer for executing the method of the invention.

Those skilled in the art will readily appreciate that various modifications and changes can be applied to the embodiments of the invention as hereinbefore described without departing from its scope, defined in and by the appended claims.

## Claims

1. A method of time calibration of a clock device operatively connected to an antenna and receiving precision time information therefrom via a cable, the method comprising:
a) generating by a measurement tool implemented within the clock device a pulse and forwarding it toward the antenna;
b) measuring, by the measurement tool, the roundtrip delay between the generated pulse and a measured signal reflected by antenna, thereby obtaining a cable delay; and
c) providing time correction in the clock device in accordance with the cable delay.

2. The method of Claim 1, further comprising continuously repeating operations a) - c), thereby enabling in-band compensation for varying cable delay.

3. The method of Claims 1 or 2, further comprising disabling antenna's powering prior to generating the pulse.

4. The method of Claims 1 or 2, further comprising:
prior to connecting the cable to the antenna, generating by the measurement tool a pulse toward the cable;
measuring, by the measurement tool, the roundtrip delay between the generated pulse and an open-end reflected signal, thereby obtaining an open-end cable delay; and
using the open-end cable delay as a baseline when obtaining the cable delay or for calculating a length of the cable.

5. The method of any one of Claims 1-4, wherein the clock device is a primary reference clock device.

6. The method of any one of Claims 1-5, further comprising switching to a measurement mode prior to generating the pulse towards the antenna, wherein the switching is provided within the clock device and comprises enabling reflected signals incoming from antenna to be routed to the measurement tool.

7. The method of any one of Claims 1 - 6, wherein measuring the roundtrip delay between the generated pulse and the measured signal reflected by antenna comprises setting a threshold value defining when a reflected signal is recognized as the measured signal reflected by antenna, and wherein a reflected signal is recognized as the measured signal when the absolute value of an amplitude thereof exceeds the threshold value.

8. The method of Claim 7, further comprising changing, by the measurement tool, the threshold value and sampling reflected signals at a sampling point corresponding to the changed threshold value.

9. The method of Claim 8, further comprising providing multiple sampling at each of several sampling points and determining the optimal sampling point enabling the minimal deviation of sampling results repeated at a specific point, wherein the measured signal reflected by antenna is sampled at the optimal sampling point.

10. A clock device operatively connected to an antenna and receiving precision time therefrom via a cable, the clock device comprising a measurement tool and configured to perform the method stages of any one of Claims 1 -9.

11. The clock device of Claim 10 configured to operate as primary reference clock device.

12. The clock device of Claims 10 or 11 comprising a GNSS, Global Navigation Satellite System, receiver operatively connected to a grandmaster clock device.

13. A GNSS receiver operatively connected to an antenna and receiving precision time therefrom via a cable, the GNSS receiver comprising a measurement tool and configured to perform the method stages of any one of Claims 1 -9.

14. A grandmaster clock device operatively connected to an antenna and receiving precision time therefrom via a cable, the grandmaster clock device comprising a measurement tool and configured to perform the method stages of any one of Claims 1 -9.
